# EUROPEAN PATENT SPECIFICATION

(11) **EP 2 325 662 B1**
(45) Date of publication and mention of the grant of the patent: **03.07.2019**
(21) Application number: 09811143.8
(22) Date of filing: 03.09.2009
(51) Int. Cl.: G01R 29/08, H05B 6/74

(54) **MULTIPLE-INPUT, MULTIPLE-OUTPUT ANALYSER**
MIMO-ANALYSATOR
SYSTÈME D'ANALYSE D'ENTRÉES MULTIPLES ET DE SORTIES MULTIPLES

(30) Priority: 03.09.2008 ES 200802584
(43) Date of publication of application: 25.05.2011
(73) Proprietor: EMITE Ingeniería, S.L., 30320 Fuente Álamo de Murcia (ES)
(72) Inventor: VALENZUELA VALDÉS, Juan Francisco, E-30310 Los Barreros - Cartagena (ES); SÁNCHEZ HERNÁNDEZ, David Agapito, 30002 Murcia (ES); MARTÍNEZ GONZÁLEZ, Antonio Manuel, E-30319 Cartagena (ES); MONZÓ CABRERA, Juan, E-30205 Cartagena (ES)
(74) Representative: Carpintero Lopez, Francisco
(86) International application number: PCT/ES2009/070364
(87) International publication number: WO 2010/026274

(56) References cited:
- WO-A1-02/056041
- ES-A1- 2 246 183
- FR-A1- 2 906 040
- JP-A- H1 026 645
- US-A1- 2006 017 630
- US-A1- 2008 099 475
- VALENZUELA-VALDES J F ET AL: "Emulation of MIMO Nonisotropic Fading Environments With Reverberation Chambers", IEEE ANTENNAS AND WIRELESS PROPAGATION LETTERS, IEEE, PISCATAWAY, NJ, US, vol. 7, 1 January 2008 (2008-01-01), pages 325-328, XP011330773, ISSN: 1536-1225, DOI: 10.1109/LAWP.2008.928488

## Description

### Field of Invention

Wireless systems that incorporate multiple inputs and multiple outputs (MIMO) for the signal are based upon turning multipath propagation, initially seen as a problem, into a solution to the limited transmission capacities. In this way, parallel transmission channels are available by increasing the number of transmitting and/or receiving antennas. Thus, high spectrum efficiencies can be achieved over the radio channel, that is, it constitutes a very competent way to satisfying the high requirements of the forthcoming Fourth Generation (4G) mobile communication systems. When the transmission channel transports energy instead of information by using high power supplies, other effects such as heating, drying and curing of materials, can be obtained.

### Background of the Invention

The multiple inputs and multiple outputs analyzer is a multimode resonant cavity with high Q factor and a very inhomogeneous spatial distribution of the electric and magnetic fields. There are various elements and methods to homogenize the fields such as: the mode-stirrers, the slotted metal pieces or moving the device under test inside the cavity. Until now stirrers have been proposed to be built of metallic materials, some of them with special shapes, which can be checked for example in the following document: WO200054365. On the other hand metallic pieces with slots are described on WO2008031964, restricting their application to the aeronautic industry.

Multimode resonant cavities are used in wireless communications applications for laboratory measurements that emulate those made for mobile terminals in different propagation scenarios with isotropic and Rayleigh distribution. Among the parameters that can be measured there are: diversity gain, MIMO capacity, antenna efficiency, absorbed power, correlation between antennas, specific absorption rate, antenna sensitivity, bit error rate (BER), (these last two have been claimed in U.S. patent 7,286,961 in a reverberation chamber). Thus, until now measurements could only be made for isotropic Rayleigh-fading environments when employing multimode resonant cavities. Furthermore, it is also possible to perform measurements with different dummies filled with fluid whose losses simulate different parts of the human body or different tissues so as to investigate, for example, the effects of a user's head in mobile terminals.

The different environments for wireless communications can be modelled by using different probability functions. Two of the most common functions to model these environments are the Rayleigh and Rician functions, with the K factor. The K factor is a parameter that defines the different types of scenarios in Rician environments. These propagating environments determine the performance of wireless communications systems operating within them. As a general rule, macro-cells have greater K factor in Rician distributions than micro-cells, that is, the component line of sight (LOS) is more dominant, and inside the cell, the K factor decreases with increasing distance to the transmitter. In contrast, the environments inside buildings and cities often have a rich multipath scattering, which is important enough to make the direct view be hardly dominant, making the statistical distribution of this environment that of a Rayleigh one. The problems is that until now only Rayleigh-fading environments could be emulated. Therefore, when a proper evaluation of terminals was desired for other types of environments, measurement campaigns in different places are required, which resulted in high cost both time and money wise.

Another application of multimode resonant cavities is heating, drying and curing with microwaves, that is, those processes that involve high power and high frequency electromagnetic fields radiated in a cavity in order to generate heat in a sample of any material. In a microwave oven the object to be heated up is placed either in an arbitrary fixed position or in a turntable that rotates in order to blend that heat as much as possible. Depending on the incident electromagnetic fields in the sample, the heating will be more or less efficient, and some procedures have already been patented, such as the one described in the document ES 2246183 to obtain the optimal heating position of the sample as a function of the electromagnetic fields. The objective is to obtain the highest possible efficiency and the highest heating homogeneity as possible. To be able to achieve that, the electromagnetic fields have to concentrate uniformly in the sample. The problems is that heating efficiency can vary from 20% to 90% depending upon the field distribution, with the existing methods, when either the size or the properties of the sample to be heated change, as the efficiency decreases since there is no possibility to change the electromagnetic field.

The document "Emulation of MIMO Nonisotropic Fading Environments With Reverberation Chambers" by Valenzuela-Valdes et al., discloses the emulation of only Rayleigh-fading environments, using a reverberation chamber with several multiple-input-multiple-outputs.

The US patent application US2008/0099475 discloses a cooking apparatus which uses microwaves to improve the uniform heating performance of the microwaves. It includes a microwave supplier for supplying microwaves into the cooking chamber and a box shaped microwave radiator with a front which is configured to be open, inside the cooking chamber.

### Description of Invention

The present invention discloses a multiple inputs and multiple outputs analyzer according to any of the claims 1-3 and a procedure according to any of the claims 4-6.

The multiple inputs and multiple outputs analyzer which is the object of this invention performs the emulation of the behaviour of a terminal with multiple antennas in all types of propagation environments or provides temperature rise of a sample inside it. Therefore, the multiple inputs and multiple outputs analyzer is capable of reproducing measurements in both isotropic and non-isotropic environments, as well as to emulate different distribution scenarios in a laboratory. Besides, it is also capable of turning a measurement environment into another one through a procedure. Therefore, the multiple inputs and multiple outputs analyzer is capable of emulating different propagation environments for multiple-antenna terminals, and it can include effects such as the presence of the human head. Likewise, when high-power sources are used, is also able to heat the sample material placed inside up with a specific heat distribution uniformity control.

The multiple inputs and multiple outputs analyzer is a type of multimode resonant cavity which includes several elements and procedures in order to perform a dynamic control of the electromagnetic fields in its interior. The elements included in the multiple inputs and multiple outputs analyzer, objects of the invention, are:
The first element included in the multiple inputs and multiple outputs analyzer is the set of a metallic piece with slots and the parts that open and close these slots, hereinafter called switching pieces. These elements are able to transform the field distribution originating from one or more antennas or sources with fixed positions into a distribution that has different sources switching between active and inactive depending upon the switching pieces opening or closing those slots. Furthermore, the switching pieces can be made of different materials. Should they be metallic, the switching function will be on/off, since the signal cannot get through the metal, while using other materials which can be penetrated by the electromagnetic waves are employed to build the switching pieces will provoke a partial activation of the source. Finally, the sources can also be partially activated by leaving the slots only partially open. The innovation that represents the partial activation of a source can provide extraordinary benefits in terms of control of the electromagnetic fields.
The second element in the multiple inputs and multiple outputs analyzer is the manufacturing of the mode stirrers using materials different from metallic materials. In this way the electromagnetic waves are not only reflected on the metallic stirrers, but also refracted. In this way it is possible to create new electromagnetic modes that can be useful for several applications.
The third element in the multiple inputs and multiple outputs analyzer is the inclusion of lenses between the signal generation systems and the systems under test. These lenses will be able, for example, to modify the K factor of the emulated environment or to concentrate in a specific way the heat that is absorbed by the sample in a given area.
The fourth element in the multiple inputs and multiple outputs analyzer is the signal generation systems being antennas that have a special shape that allows them to operate over a wide frequency bandwidth, which in turn enables the multiple inputs and multiple outputs analyzer to be used in a large portion of the spectrum.
The fifth element in the multiple inputs and multiple outputs analyzer is the introduction of elements with losses such as liquids with losses in any position or absorbing cones placed in the walls of the multimode resonant cavity. In this way an isotropic environment is transformed into a non-isotropic one and power absorption in the material in its interior can be modulated.

The first procedure performed by the claimed multiple inputs and multiple outputs analyzer is to implement any of the above five elements independently or in a combination in order to get a particular electromagnetic field distribution in the test volume. This procedure can provide the particular field distribution which is useful for any application.

The second procedure performed by the multiple inputs and multiple outputs analyzer is the location of the elements under test outside the cavity. The link between the outside and inside part of the cavity will be achieved by either leaving the door of the cavity partially open through the use of diverse aperture angles or by using slots with different shapes and sizes that communicate the inside to the outside of the cavity. In this way the propagation environment will abandon the typical isotropic distribution (which is a uniform distribution of power in all possible angles of arrival) and will become non-isotropic because the main part of the signal will propagate through the open door or through the slots in the cavity walls.

The third procedure performed by the multiple inputs and multiple outputs analyzer is the evaluation of different Rician-fading environments from a single Rayleigh measurement, in a way that with a single measurement the MIMO analyzer can emulate the whole range of existing K factors with the consequent savings in both time and money.

This invention can be useful in the field of microwave heating, drying and curing of materials. In the following paragraphs its potential use in this field is described.

With the first element, that is, the metallic piece with apertures and switching pieces, the electromagnetic field distribution can be made more uniform as well as the radiation efficiency can be maximized at the sample in accordance to the sample's type of material. Therefore, certain apertures will be open and/or closed depending upon the sample's characteristics, enabling a high efficiency in heating, drying and curing of different materials. This will therefore increase the oven versatility, which provides a clear advantage.

The second element is the building of mode stirrers of non-metallic elements. This allows for an homogenization in the electromagnetic field, as well as avoids reflections to sources or magnetrons, maximizing the process efficiency.

The third element, the use of lenses, allows for a concentration of electromagnetic fields in the sample if we are using converging lenses, which produces a significant increase in the process efficiency. On the other hand, if diverging lenses are used, there will be a scattering of electromagnetic fields leading to a homogenization of the field in the sample, causing a more uniform heating, drying or curing of the entire sample.

By the previous elements it is possible to control and modify the electromagnetic fields in the sample, that is, a procedure similar to what is described in patent ES 2246183 can be developed. The combination of the variation of different apertures in element one combined with a specific position of the mode stirrers and the use or not use of the lenses can provide a maximum sample heating efficiency while the electromagnetic field distribution is homogenized over it.

### In the drawings:

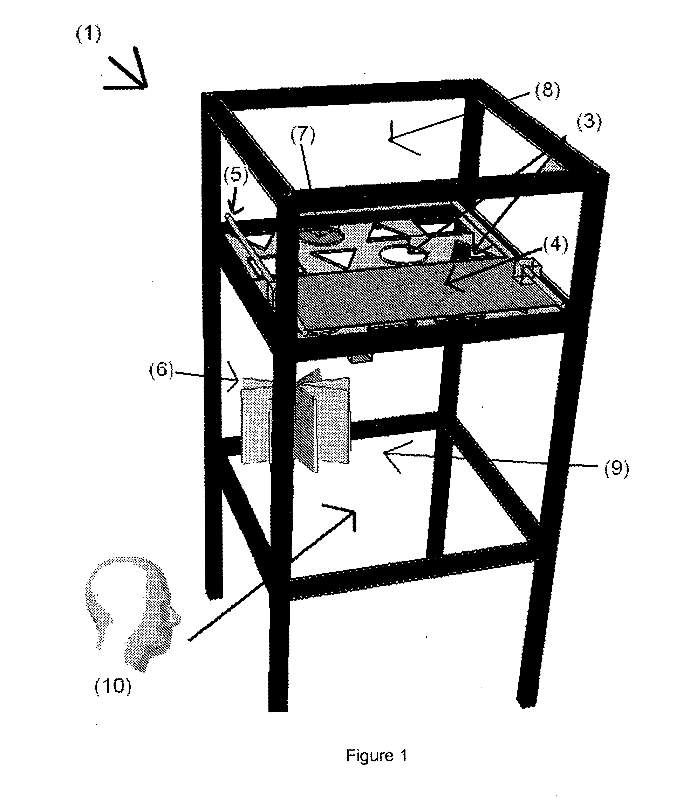

Figure 1 shows a multiple inputs and multiple outputs analyzer (1) which comprises the following elements: a slotted piece (2) that separates the transmitter and the receiver, mobile switching pieces (4) through some axes (5) which leave various slots (3) of the metallic piece (2) open or closed, a non-metallic mode stirrer (6), a lens (7) embedded in one of the circular slots and broadband antennas (8). The volume where the elements under test (9) would be located is also indicated. In this volume (9) other elements can also be placed such as dummies (10) in order to simulate the effect of life beings.

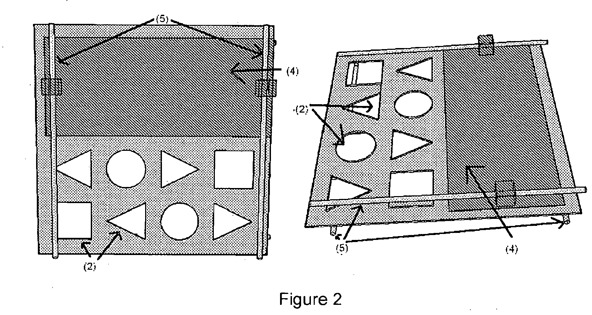

Figure 2 illustrates a detail of the first element, that is, the piece with slots (2), the metallic pieces (4) that are moved closing or opening the different slots (3) and the axes (5), through which the piece that opens or closes the slots moves.

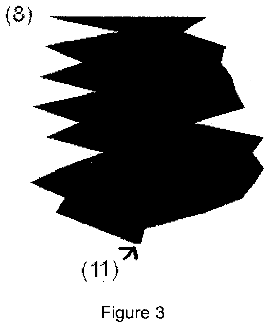

Figure 3 shows in detail the characteristic shape of the signal transmission elements or antennas (8) specific for the multiple inputs and multiple outputs analyzer, and their feed point (11).

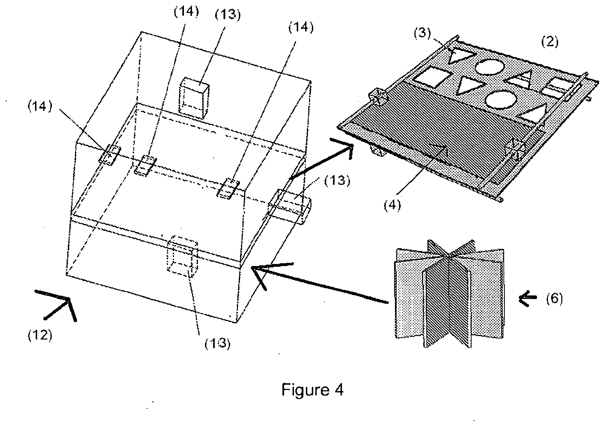

Figure 4 shows a multiple inputs and multiple outputs analyzer to be employed in microwave heating applications (12) with the following elements: three sources or magnetrons (13), several samples (14), a mode stirrer (6) and a slotted metallic piece (2).
Figure 5 shows the diversity gain versus the K-factor for the arrays with the probability level as a parameter. This is an example of the performance analyses and evaluation that the multiple inputs and multiple outputs analyzer can perform.
Figure 6 shows the diversity gain versus cumulative probability level for the arrays. This is an example of the performance analyses and evaluation that the multiple inputs and multiple outputs analyzer can perform.
Figure 7 shows the dry-basis moisture content drying curve versus time for samples 01, 02, 03 and 04 with a power supply of 700 W.
Figure 8 illustrates dry-basis moisture content drying curve versus time for samples 05, 06 and 07 with a power supply of 540 W.

### Realization mode of the invention

The following examples help illustrating the present invention, but they must not be taken as restrictions of its capabilities.

### Example 1. Multiple inputs and multiple outputs analyzer for wireless communications.

In the favourite mode of the multiple inputs and multiple outputs analyzer (1), the number of slots (3) in the metallic piece (2) is 16, which are open or closed by the metallic pieces (4) located above and below that metallic piece. In this favourite mode of the multiple inputs and multiple outputs analyzer (1) there is a lens (7) in one of the slots (3) in a circular shape. The mode stirrers (6) are located below the metallic piece (2). The signal transmission elements (8) are broadband antennas located in the upper part of the multiple inputs and multiple outputs analyzer. Both liquid-filled receptacles with losses and absorbent materials can be introduced in test volume (9), as well as dummies or other elements that allow the emulation of life beings. This multiple inputs and multiple outputs analyzer presents the following novelties:
The possibility of emulating Rayleigh-fading environments by the slotted metallic piece (2) with slots that are being open and closed, causing an electric field distribution with that function; and by using the divergent lenses (7).

The possibility of emulating Rician environments with different K-factors by several techniques: concentrating the direct ray though a convergent lens and with the procedure that control the electromagnetic field on the test volume in a way to alter the ratio between the direct ray and reflected rays.

The possibility of emulating non-isotropic environments by several techniques: by means of measuring outside the cavity and by placing materials with losses inside the analyzer.

The possibility of emulating environments with any distribution by using the procedure that controls the electromagnetic field.

The possibility of emulating environments with a Rician distribution from Rayleigh environments.

The multiple inputs and multiple outputs analyzer favourite mode has been designed to be used in the field of wireless communications. This mode allows for an emulation of any of fading environment through different techniques, providing a competitive advantage versus conventional multimode resonant cavities which can emulate just Rayleigh-fading and isotropic environments. As an example, a diversity gain analysis from several three-input and three-output arrays in different Rician environments is shown. The spatial separations between adjacent elements in the different arrays are: 0.01 d/λ for array A, 0.05 d/λ for array B and 0.1 d/λ for array C.

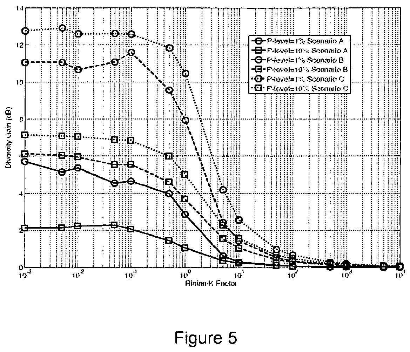

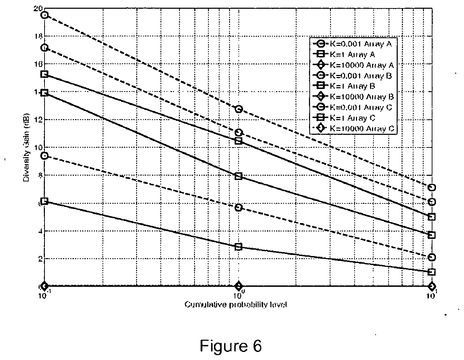

The diversity gain analysis of figures 5 and 6 has been performed in the multiple inputs and multiple outputs analyzer. Figure 5 shows the diversity gain versus the K-factor for all arrays and a cumulative probability ranging from 1% to 10%. From this graph some equivalences of different arrays can be extracted. For example, for a 1% probability, the diversity gain of array A with K=0.001 (DG= 5.8 dB) is equivalent to that of array B with K=2 and that of array C with K=3.5. For a 10% probability, the performance in terms of diversity gain of array B with K=3 is equivalent to that of array C with K=6 (DG=2.2dB). Another equivalent situation if that of array B with K=0.001 and array C with K=0.8 for a 1% probability. With these comparisons one can extract which factor causes a stronger influence on final diversity gain performance: the propagation environment type or the receive array configuration.

Figure 6 shows the measured diversity gain versus cumulative probability for several K-factor values and all arrays. It can be observed that the same results are obtained at K=10000 for all arrays and all values of cumulative probability. A performance comparison for any given value of diversity gain can be performed. For example, if we want to achieve an 8 dB diversity gain in all arrays, the following combinations have to be taken: there is only one option for array A, p=0.18% and K=0.001; there are two options for array B, p=4.1% and K=0.001 or p=1% and K=1; and there are another two options for array C, p=3.5% and K=0.001 or p=6% and K=1. With these comparisons one can extract which factor causes a stronger influence: the probability level at which the system is evaluated or the different arrays on their corresponding propagating environment.

As it is well known, the diversity gain depends upon the array being used, the probability level at which it is going to be evaluated and the propagation environment. These three factors have to be combined in an optimum manner by the designer in order to use the available resources in an optimum manner. It is for this reason that the multiple inputs and multiple outputs analyzer is a very useful tool for the designer of systems with multiple inputs and multiple outputs in wireless communications.

### Example 2. Multiple inputs and multiple outputs analyzer for microwave heating.

The use of the multiple inputs and multiple outputs analyzer inventive elements for drying, curing and microwave heating is shown in favourite mode number two. This favourite mode is an applicator (12) equipped with a metallic piece to concentrate the field (2) and maximize the efficiency, as well as a non-metallic stirrer (6) is located to maximize both efficiency and homogenization of fields on the sample. Depending on the material to be heated, its position and size, some specific slots or others will be open in order to achieve, through procedure number one, the above-mentioned objectives (efficiency maximization and heating, drying and curing homogenization). This applicator is intended for industrial use and it has the following advantages versus other applicators:
It achieves a maximization of the efficiency, which involves cost savings.

It provides heating, drying and curing homogenization, which increases the quality of most of the products.

In can be set-up for different materials, which means greater functionality and versatility.

As an example, a homogenization analysis of leather samples with different initial moisture contents and for different power levels of the sources is shown. The samples had the following initial moisture contents: 1.85, 1.81, 0.73, 0.46, 1.40, 0.58 and 0.32 for samples 01, 02, 03, 04, 05, 06 and 07, respectively.

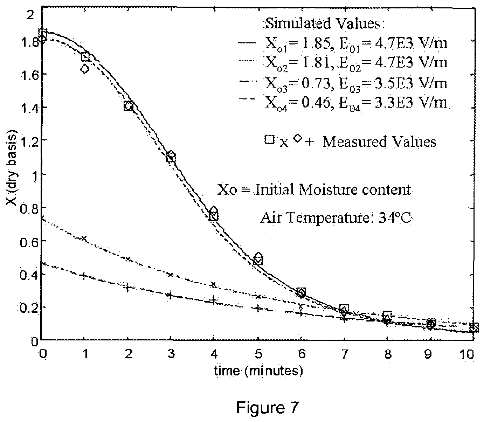

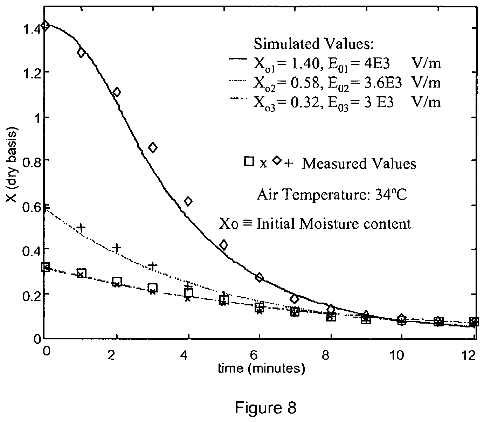

The homogenization analysis made in figures 7 and 8 has been performed by measurements with the multiple inputs and multiple outputs analyzer. Figure 7 shows the samples' moisture content on dry basis drying curve versus time for samples 01, 02, 03 and 04 and 700 W power. From this figure we can conclude that moisture homogenization is completed in only 7 minutes, with all samples achieving the same moisture content at that time but at different speeds depending on their initial moisture content.

Figure 8 shows the samples' moisture content on dry basis drying curve versus time for samples 05, 06 and 07 and 540 W source power. From this graph we can extract that in this case at least 10 minutes are needed. But that the moisture content homogenization is also completed in all samples. Again, all samples achieve the same moisture content but also at different speeds depending on their initial moisture content.

It is well known that microwave drying is strongly influenced by the electromagnetic field distribution on the sample, the sample's loss factor and its moisture content. These three factors must be combined in an optimal manner by the system designer in order to optimize the use of the available resources. For this reason the multiple inputs and multiple outputs analyzer is a very useful element for the industrial microwave heating applicator designer.

## Claims

1. A multiple inputs and multiple outputs analyzer (1), which is a multimode resonant cavity comprising the following elements:
- a separating element (2) that separates signal transmission systems from signal reception systems, wherein the separating element is a slotted piece;
- the separating element (2) incorporating mobile switching pieces (4) above and below the separating element (2) to leave the slots (3) of the slotted piece open, partially open or closed;
- axes (5) along which the mobile switching pieces (4) move;
- one or more mode stirrers (6);
- one or more lenses (7);
- signal transmission means and signal reception means.

2. A multiple inputs and multiple outputs analyzer, according to claim 1, **characterized by** comprising mode stirrers (6) being built of a non-metallic element, so that it allows the partial penetration of the electromagnetic fields.

3. A multiple inputs and multiple outputs analyzer (1), according to claim 1, **characterized by** the fact of containing broadband antennas (8).

4. A procedure which uses the multiple inputs and multiple outputs analyzer described in claim 1, for emulating different propagation environments for wireless communication systems.

5. A procedure according to claim 4 **characterized by** placing materials with losses into the multiple inputs and multiple outputs analyzer.

6. A procedure according to claim 4, **characterized by** placing a dummy filled with different liquids into the multiple inputs and multiple outputs analyzer.

## Patentansprüche

1. Ein analysator mit mehreren eingängen und mehreren ausgängen bestehend aus einer multimode resonanzröhre, die folgende bestandteile enthält:
- Ein separierendes element (2) welches die signale der transmissionssysteme von der empfangsanlage trennt, wobei das trennende element ein geschlitztes bauteil ist;
- Das separierende element (2) integriert an der ober und unterseite mobile schaltelemente (4), um die schlitze (3) dieses bauelements zu verlassen zu können, weches oben, teils offen, teils geschlossen ist;
- Achsen (5), entlang denen sich die beweglichen schaltstücke (4) bewegen;
- Ein oder mehrmodus agitator (7);
- Signalübertragungsmittel und signalempfangsmittel.

2. Analysator mit mehreren eingängen und mehreren ausgängen, gemäss anspruch 1, **dadurch gekennzeichnet, dass** mode agitatores (6) aus einem nichtmetallischen element aufgebaut sind, so dass sie das teilweise eindringen der elektromagnetischen felder ermöglichen.

3. Ein analysator (1) mit mehreren eingängen und mehreren ausgängen gemäss anspruch 1, **dadurch gekennzeichnet, dass** er breitbandantennen (8) enthält.

4. Eine verfahrensweise, das den analysator mit mehreren eingängen und mehreren ausgängen einsetzt, wie in anspruch 1 beschrieben, zum emulieren verschiedener ausbreitungsumgebungen für drahtlose kommunikationssysteme.

5. Verfahrensweise gemäss anspruch 4 dadurch charakterisiert, dass materialien mit verlusten in den analysator für mehrere eingänge und mehrere ausgänge platziert werden.

6. Verfahrensweise gemäss anspruch 4, **dadurch gekennzeichnet, dass** ein mit verschiedenen flüssigkeiten gefüllter dummy in den analysator für mehrere eingänge und mehrere ausgänge platziert wird.

## Revendications

1. Un analyseur à entrées multiples et sorties multiples (1), qui est une cavité résonante multimode comprenant les éléments suivants:
- un élément de séparation (2) qui sépare les systèmes de transmission de signaux des systèmes de réception de signaux, dans lequel l'élément de séparation est une pièce fendue;
- l'élément de séparation (2) incorporant des éléments de commutation mobiles (4) au-dessus et au-dessous de l'élément de séparation (2) afin de laisser les fentes (3) de la pièce fendue ouvertes, partiellement ouvertes ou fermées;
- des axes (5) le long desquels se déplacent les éléments de commutation mobiles (4);
- un ou plusieurs agitateurs de mode (6);
- une ou plusieurs lentilles (7);
- des moyens de transmission de signaux et des moyens de réception de signaux.

2. Un analyseur à entrées multiples et sorties multiples, selon la revendication 1, **caractérisé en ce qu'**il comprend des agitateurs de mode (6) constitués d'un élément non métallique, de sorte qu'il permette la pénétration partielle des champs électromagnétiques.

3. Un analyseur à entrées multiples et sorties multiples (1), selon la revendication 1, **caractérisé par** le fait de contenir des antennes à large bande (8).

4. Une procédure qui utilise l'analyseur à entrées multiples et sorties multiples décrit dans la revendication 1, pour émuler différents environnements de propagation pour des systèmes de communication sans fil.

5. Une procédure selon la revendication 4, **caractérisé en ce qu'**il consiste à placer des matériaux avec des pertes dans l'analyseur à entrées multiples et sorties multiples.

6. Une procédure selon la revendication 4, **caractérisée en ce que** l'on place un mannequin rempli de différents liquides dans l'analyseur à entrées multiples et sorties multiples.
